# EUROPEAN PATENT APPLICATION

(11) **EP 2 787 553 A1**
(43) Date of publication of application: **08.10.2014**
(21) Application number: 11876540.3
(22) Date of filing: 28.11.2011
(51) Int. Cl.: H01L 51/54, H05B 33/14

(54) **DOPED ORGANIC ELECTROLUMINESCENT DEVICE AND METHOD FOR PREPARING SAME**

(71) Applicant: Ocean's King Lighting Science & Technology Co., Ltd., Guangdong 518054 (CN); Shenzhen Ocean's King Lighting Engineering Co. Ltd., Guangdong 518054 (CN)
(72) Inventor: ZHOU, Mingjie, Shenzhen, Guangdong 518054 (CN); WANG, Ping, Shenzhen, Guangdong 518054 (CN); HUANG, Hui, Shenzhen, Guangdong 518054 (CN); FENG, Xiaoming, Shenzhen, Guangdong 518054 (CN)
(74) Representative: Brunetti, Fabrizio
(86) International application number: PCT/CN2011/083048
(87) International publication number: WO 2013/078593

(57) **Abstract**

Disclosed is a doped organic electroluminescent device, comprising the following structures laminated in succession: a conductive anode substrate, a hole injecting layer, a hole transportation layer, an electron barrier layer, a light-emitting layer, an electron transportation layer, an electron injecting layer and a cathode; and the material for the electron barrier layer is a hole transportation material doped with a cerium salt. The material for an electron barrier layer in such a doped organic electroluminescent device is a hole transportation material doped with a cerium salt which has a low work function of approximately -2.0 eV and can effectively block electrons. By doping the cerium salt having a low work function into the hole transportation material as the electron barrier layer, the LUMO energy level of the hole transportation material is greatly increased, thereby elevating the potential barrier between the electron barrier layer and the light-emitting layer, so that it is difficult for the electrons to transit to the side of the hole transportation layer and a good electron barrier effect is achieved. The present invention also provides a method for preparing the doped organic electroluminescent device.

## Description

### TECHNICAL FIELD

The present invention relates to the field of organic electroluminescence, especially to a doped organic electroluminescent device and a method for preparing the same.

### BACKGROUND ART

In 1987, C. W. Tang and VanSlyke of Eastman Kodak Company, USA, reported a breaking-through progress in the research of organic electroluminescence: a high-brightness, high efficiency double-layer doped organic electroluminescent device (OLED) was prepared using ultra-thin film technique. In this double-layer device, the brightness at 10 V reached 1000 cd/m², the luminous efficiency was 1.51 lm/W, and the service life was above 100 hours.

The principle of the light emission of OLED is based on that, under the effect of an applied electric field, electrons are injected from the cathode to the lowest unoccupied molecular orbital (LUMO) of an organic material, while holes are injected from the anode into the highest occupied molecular orbital (HOMO) of the organic material. Electrons and holes meet each other in the light-emitting layer, recombine with each other, forming excitons which migrate under the effect of the electric field, transferring energy to the light-emitting material and exciting electrons to transit from ground state to excited state. The excited state energy is inactivated by radiation, which produces photons and releases energy.

In conventional doped organic electroluminescent devices, if the potential barrier between the LUMO energy levels of the light-emitting layer and the hole transport layer is low, electrons may travel from the light-emitting layer to the hole transport layer, leading to ineffective recombination of electrons and holes, and low luminous efficiency. The traditional approach to block electrons is to deposit a layer of an organic material having a LUMO energy level of about -3.2 eV between the light-emitting layer and the hole transport layer to block electrons and restrict electrons within the light-emitting layer. Usually, the electrons can be effectively blocked only when the potential barrier between the LUMOs of the electron blocking layer and the light-emitting layer is about 0.5 eV. However, the LUMO energy level of the light-emitting layer of the conventionally used doped organic electroluminescent devices is about -3.5 eV. Accordingly, the blocking effect is poor.

### SUMMARY OF THE INVENTION

Based on this, it is necessary to provide a doped organic electroluminescent device which has a good electron blocking effect.

An doped organic electroluminescent device may comprise a conductive anode substrate, a hole injection layer, a hole transport layer, an electron blocking layer, a light-emitting layer, an electron transport layer, an electron injection layer and a cathode, which may be sequentially stacked; a material for the electron blocking layer may be a hole transport material doped with a cesium salt.

The cesium salt may account for 2% to 15% by mass of the electron blocking layer.

Preferably, the cesium salt may be cesium azide, cesium carbonate, cesium fluoride, or cesium oxide.

Preferably, the hole transport material may be 1,1-bis[4-[N,N'-di(p-tolyl)amino] phenyl]cyclohexane, N,N'-di(3-methylphenyl)-N,N'-diphenyl-4,4'-biphenyl diamine, 4,4',4"-tris(carbazol-9-yl)triphenyl amine, or N,N'-(1-naphthyl)-N,N'-diphenyl-4,4'-biphenyl diamine.

Preferably, the electron blocking layer may have a thickness of 1 nm to 10 nm.

Preferably, a material for the hole injection layer may be molybdenum trioxide, tungsten trioxide or vanadium pentoxide.

Preferably, a material for the hole transport layer may be 1,1-bis[4-[N,N'-di(p-tolyl) amino]phenyl]cyclohexane, N,N'-di(3-methylphenyl)-N,N'-diphenyl-4,4'-biphenyl diamine, 4,4',4"-tris(carbazol-9-yl)triphenyl amine, or N,N'-(1-naphthyl)-N,N'-diphenyl-4,4'- biphenyl diamine.

Preferably, a material for the light-emitting layer may be at least one of 4-(dicyanomethylene)-2-isopropyl-6-(1,1,7,7-tetramethyljulolidin-9-yl-vinyl)-4H-pyran, 8-hydroxyquinoline aluminum, bis(4,6-difluorophenylpyridine-N,C²) picolinatoiridium, bis(2-methyl- dibenzo[f,h]quinoxaline) (acetylacetonato) iridium and tris(2-phenylpyridine) iridium.

Alternatively, a material of the light-emitting layer may be a mixed material comprising 4-(dicyanomethylene)-2-isopropyl-6-(1,1,7,7-tetramethyljulolidin-9-yl-vinyl)-4H-pyran, 8-hydroxyquinoline aluminum, bis(4,6-difluorophenylpyridine-N,C²) picolinatoiridium, bis(2-methyl-dibenzo[f,h]quinoxaline) (acetylacetonato) iridium or tris(2-phenylpyridine) iridium as a guest material and one or two of 1,1-bis[4-[N,N'-di(p-tolyl)amino]phenyl]cyclohexane, N,N'-di(3-methylphenyl)-N,N'-diphenyl-4,4'-biphenyl diamine, 4,4',4"-tris(carbazol-9-yl)triphenyl amine, N,N'-(1-naphthyl)-N,N'-diphenyl-4,4'-biphenyl diamine, 2-(4-biphenylyl)-5-(4-tert-butyl)phenyl-1,3,4-oxadiazole, 8-hydroxyquinoline aluminum, 4,7-diphenyl-1,10-phenanthroline, 1,2,4-triazole derivatives and N-arylbenzimidazole as a host material, wherein the guest material may account for 1% to 20% by mass of the mixed material.

Preferably, a material for the electron transport layer may be 2-(4-biphenylyl)-5-(4-tert-butyl)phenyl-1,3,4-oxadiazole, 8-hydroxyquinoline aluminum, 4,7-diphenyl- 1,10-phenanthroline, 1,2,4-triazole derivatives or N-arylbenzimidazole.

Preferably, a material for the electron injection layer may be lithium carbonate, lithium chloride or lithium fluoride.

A method for preparing a doped organic electroluminescent device may comprise the steps of:
conducting a pretreatment on a conductive anode substrate;
sequentially forming a hole injection layer and a hole transport layer on the conductive anode substrate by vapor deposition;
providing a hole transport material doped with a cesium salt on the hole transport layer by vapor deposition to form an electron blocking layer; and
sequentially forming a light-emitting layer, an electron transport layer and an electron injection layer and finally a cathode on the electron blocking layer by vapor deposition to give the doped organic electroluminescent device.

The material for the electron blocking layer of this kind of doped organic electroluminescent device is a hole transport material doped with a cesium salt. As the cesium salt has a low work function of about -2.0 eV, it can effectively block electrons. By using a hole transport material doped with a cesium salt, which has a low work function, as the electron blocking layer, the LUMO energy level of the hole transport material is greatly enhanced and the potential barrier between the electron blocking layer and the light-emitting layer is increased, so that electrons are difficult to transit to the side of the hole transport layer. The electron blocking effect is better, so that electrons are restricted in the light-emitting layer to recombine with holes.

### BRIEF DESCRIPTION OF THE FIGURES

Fig. 1 is a schematic structure of a doped organic electroluminescent device according to one embodiment;
Fig. 2 is a flowchart of a method for preparing a doped organic electroluminescent device according to one embodiment;
Fig. 3 illustrates the relationship between the energy efficiency and the current density of the doped organic electroluminescent device prepared in Example 1 and a conventional doped organic electroluminescent device.

### SPECIFIC EMBODIMENTS

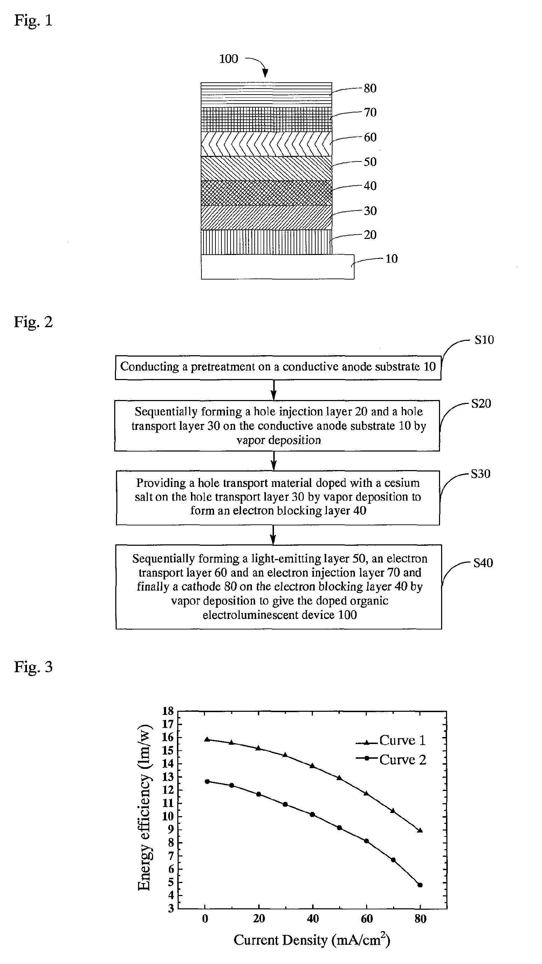

According to an embodiment as shown in Fig. 1, a doped organic electroluminescent device 100 comprises a conductive anode substrate 10, a hole injection layer 20, a hole transport layer 30, an electron blocking layer 40, a light-emitting layer 50, an electron transport layer 60, an electron injection layer 70 and a cathode 80, which are sequentially stacked.

The material for the conductive anode substrate 10 may be indium tin oxide glass (ITO), fluorine-doped tin oxide glass (FTO), aluminum-doped zinc oxide (AZO), or indium-doped zinc oxide (IZO).

The material for the hole injection layer 20 may be molybdenum trioxide (MoO₃), tungsten trioxide (WO₃) or vanadium pentoxide (V₂O₅), and the thickness thereof may be 20 nm to 80 nm.

Preferably, the material for the hole injection layer 20 is MoO₃, and the thickness thereof is 40 nm.

The material for the hole transport layer 30 may be 1,1-bis[4-[N,N'-di(p-tolyl)amino] phenyl]cyclohexane (TAPC), N,N'-di(3-methylphenyl)-N,N'-diphenyl-4,4'-biphenyl diamine (TPD), 4,4',4"-tris(carbazol-9-yl)triphenyl amine (TCTA), or N,N'-(1-naphthyl)-N,N'-diphenyl-4,4'-biphenyl diamine (NPB), and the thickness thereof may be 20 nm to 60 nm.

Preferably, the material for the hole transport layer 30 is NPB, and the thickness thereof is 40 nm.

The material for the electron blocking layer 40 may be a hole transport material doped with a cesium salt.

The cesium salt may account for 2% to 15% by mass of the electron blocking layer 40.

The cesium salt may be cesium azido, cesium carbonate, cesium fluoride, or cesium oxide.

The hole transport material may be 1,1-bis[4-[N,N'-di(p-tolyl)amino]phenyl] cyclohexane (TAPC), N,N'-di(3-methylphenyl)-N,N'-diphenyl-4,4'-biphenyl diamine (TPD), 4,4',4"-tris(carbazol-9-yl)triphenyl amine (TCTA), or N,N'-(1-naphthyl)-N,N'-diphenyl-4,4'- biphenyl diamine (NPB).

The electron blocking layer 40 may have a thickness of 1 nm to 10 nm.

The material for the light-emitting layer 50 may be at least one of 4-(dicyanomethylene)-2-butyl-6-(1,1,7,7-tetramethyljulolidin-9-yl-vinyl)-4H-pyran (DCJTB), 8-hydroxyquinoline aluminum (Alq₃), bis(4,6-difluorophenylpyridine-N,C²) picolinatoiridium (FIrpic), bis(2-methyl-dibenzo[f,h]quinoxaline) (acetylacetonato) iridium (Ir(MDQ)₂(acac)) and tris(2-phenylpyridine) iridium (Ir(ppy)₃).

Alternatively, the material for the light-emitting layer 50 may be a mixed material comprising
4-(dicyanomethylene)-2-butyl-6-(1,1,7,7-tetramethyljulolidin-9-yl-vinyl)- 4H-pyran (DCJTB), 8-hydroxyquinoline aluminum (Alq₃), bis(4,6-difluorophenylpyridine-N,C²) picolinatoiridium (FIrpic), bis(2-methyl-dibenzo[f,h]quinoxaline) (acetylacetonato) iridium (Ir(MDQ)₂(acac)) or tris(2-phenylpyridine) iridium (Ir(ppy)₃) as a guest material and one or two of a hole transport material and a electron transport material as a host material, wherein the guest material may account for 1% to 20% by mass of the mixed material, wherein the hole transport material may be 1,1-bis[4-[N,N'-di(p-tolyl)amino]phenyl]cyclohexane (TAPC), N,N'-di(3-methylphenyl)-N,N'-diphenyl-4,4'-biphenyl diamine (TPD), 4,4',4"-tris(carbazol-9-yl)triphenyl amine (TCTA) or N,N'-(1-naphthyl)-N,N'-diphenyl-4,4'-biphenyl diamine (NPB), and the electron transport material may be 2-(4-biphenylyl)-5-(4-tert-butyl)phenyl-1,3,4-oxadiazole (PBD), 8-hydroxyquinoline aluminum (Alq₃), 4,7-diphenyl-1,10-phenanthroline (Bphen), 1,2,4-triazole derivatives (e.g., TAZ) or N-arylbenzimidazole (TPBI).

The light-emitting layer 50 may have a thickness of 2 nm to 50 nm.

Preferably, the material for the light-emitting layer 50 is Alq3, and the thickness thereof is 30 nm.

The material for the electron transport layer 60 may be 2-(4-biphenylyl)-5-(4-tert-butyl)phenyl-1,3,4-oxadiazole (PBD), 8-hydroxyquinoline aluminum (Alq₃), 4,7-diphenyl- 1,10-phenanthroline (Bphen), 1,2,4-triazole derivatives (e.g., TAZ) or N-arylbenzimidazole (TPBi), and the thickness thereof may be 40 to 80 nm.

Preferably, the material for the electron transport layer 60 is TPBi, and the thickness thereof is 60 nm.

The material for the electron injection layer 70 may be lithium carbonate (Li₂CO₃), lithium chloride (LiCl) or lithium fluoride (LiF), and the thickness thereof may be 0.5 nm to 5 nm.

Preferably, the material for the electron injection layer 70 is LiF, and the thickness thereof is 0.7 nm.

The material for the cathode 80 may be silver (Ag), aluminum (Al), platinum (Pt) or gold (Au), and the thickness thereof may be 80 nm to 250 nm.

Preferably, the material for the cathode 80 is Ag, and the thickness thereof is 100 nm.

The material for the electron blocking layer 40 of this kind of doped organic electroluminescent device 100 is a hole transport material doped with a cesium salt.

As the cesium salt has a low work function of about -2.0 eV, it can effectively block electrons. By using a hole transport material doped with a cesium salt, which has a low work function, as the electron blocking layer 40, the LUMO energy level of the hole transport material is greatly enhanced and the potential barrier between the electron blocking layer 40 and the light-emitting layer 50 is increased, so that electrons are difficult to transit to the side of the hole transport layer 30. The electron blocking effect is better, so that electrons are restricted in the light-emitting layer 50 to recombine with holes.

Meanwhile, the hole transport material in the electron blocking layer 40 may further improve the hole transport rate, and ultimately increase the probability of exciton recombination, thereby increasing the luminous efficiency.

In addition, such a doped electron blocking layer 40 is simple to prepare, and the production efficiency of the doped organic electroluminescent device 100 can be greatly improved.

As shown in Fig. 2, a method for preparing the doped organic electroluminescent device 100 described above comprises the following steps.

Step S10: conducting a pretreatment on a conductive anode substrate 10.

The material for the conductive anode substrate 10 may be indium tin oxide glass (ITO), fluorine-doped tin oxide glass (FTO), aluminum-doped zinc oxide (AZO), or indium-doped zinc oxide (IZO).

The pretreatment comprises the steps of cleaning the conductive anode substrate 10, and conducting an oxygen plasma treatment on the conductive anode substrate 10.

Specifically, the conductive anode substrate 10 is first washed sequentially with a detergent, deionized water, acetone, ethanol and isopropyl alcohol under sonication, each for 15 min, to remove organic dirt from the surface of the conductive anode substrate 10. After cleaning, the conductive anode substrate 10 is subjected to an oxygen plasma treatment.

The oxygen plasma treatment may be conducted for 2 min to 15 min at a power of 10 W to 50 W. Preferably, the oxygen plasma treatment is conducted for 5 min at a power of 35 W.

Step S20: sequentially forming a hole injection layer 20 and a hole transport layer 30 on the conductive anode substrate 10 by vapor deposition.

A hole injection layer 20 and a hole transport layer 30 may be formed sequentially on the conductive anode substrate 10 by vacuum vapor deposition.

The material for the hole injection layer 20 may be molybdenum trioxide (MoO₃), tungsten trioxide (WO₃) or vanadium pentoxide (V₂O₅), and the thickness thereof may be 20 nm to 80 nm.

Preferably the material for the hole injection layer 20 is MoO₃, and the thickness thereof is 40 nm.

The material for the hole transport layer 30 may be 1,1-bis[4-[N,N'-di(p-tolyl)amino] phenyl]cyclohexane (TAPC), N,N'-di(3-methylphenyl)-N,N'-diphenyl-4,4'-biphenyl diamine (TPD), 4,4',4"-tris(carbazol-9-yl)triphenyl amine (TCTA), or N,N'-(1-naphthyl)-N,N'-diphenyl-4,4'-biphenyl diamine (NPB), and the thickness thereof may be 20 nm to 60 nm.

Preferably, the material for the hole transport layer 30 is NPB, and the thickness thereof is 40 nm.

Step S30: providing a hole transport material doped with a cesium salt on the hole transport layer 30 by vapor deposition to form an electron blocking layer 40.

The material for the electron blocking layer 40 may be a hole transport material doped with a cesium salt.

The cesium salt may account for 2% to 15% by mass of the electron blocking layer 40.

The cesium salt may be cesium azido, cesium carbonate, cesium fluoride, or cesium oxide.

The hole transport material may be 1,1-bis[4-[N,N'-di(p-tolyl)amino]phenyl] cyclohexane (TAPC), N,N'-di(3-methylphenyl)-N,N'-diphenyl-4,4'-biphenyl diamine (TPD), 4,4',4"-tris(carbazol-9-yl)triphenyl amine (TCTA), or N,N'-(1-naphthyl)-N,N'-diphenyl-4,4'- biphenyl diamine (NPB).

The electron blocking layer 40 may have a thickness of 1 nm to 10 nm.

Step S40: sequentially forming a light-emitting layer 50, an electron transport layer 60 and an electron injection layer 70 and finally a cathode 80 on the electron blocking layer 40 by vapor deposition to give the doped organic electroluminescent device 100.

The material for the light-emitting layer 50 may be at least one of 4-(dicyanomethylene)-2-butyl-6-(1,1,7,7-tetramethyljulolidin-9-yl-vinyl)-4H-pyran (DCJTB), 8-hydroxyquinoline aluminum (Alq₃), bis(4,6-difluorophenylpyridine-N,C²) picolinatoiridium (FIrpic), bis(2-methyl-dibenzo[f,h]quinoxaline) (acetylacetonato) iridium (Ir(MDQ)₂(acac)) and tris(2-phenylpyridine) iridium (Ir(ppy)₃).

Alternatively, the material for the light-emitting layer 50 may be a mixed material comprising
4-(dicyanomethylene)-2-butyl-6-(1,1,7,7-tetramethyljulolidin-9-yl-vinyl)- 4H-pyran (DCJTB), 8-hydroxyquinoline aluminum (Alq₃), bis(4,6-difluorophenylpyridine-N,C²) picolinatoiridium (FIrpic), bis(2-methyl-dibenzo[f,h]quinoxaline) (acetylacetonato) iridium (Ir(MDQ)₂(acac)) or tris(2-phenylpyridine) iridium (Ir(ppy)₃) as a guest material and one or two of a hole transport material and a electron transport material as a host material, wherein the guest material may account for 1% to 20% by mass of the mixed material, wherein the hole transport material may be 1,1-bis[4-[N,N'-di(p-tolyl)amino]phenyl]cyclohexane (TAPC), N,N'-di(3-methylphenyl)-N,N'-diphenyl-4,4'-biphenyl diamine (TPD), 4,4',4"-tris(carbazol-9-yl)triphenyl amine (TCTA) or N,N'-(1-naphthyl)-N,N'-diphenyl-4,4'-biphenyl diamine (NPB), and the electron transport material may be 2-(4-biphenylyl)-5-(4-tert-butyl)phenyl-1,3,4-oxadiazole (PBD), 8-hydroxyquinoline aluminum (Alq₃), 4,7-diphenyl-1,10-phenanthroline (Bphen), 1,2,4-triazole derivatives (e.g., TAZ) or N-arylbenzimidazole (TPBI).

The light-emitting layer 50 may have a thickness of 2 nm to 50 nm.

Preferably, the material for the light-emitting layer 50 is Alq3, and the thickness thereof is 30 nm.

The material for the electron transport layer 60 may be 2-(4-biphenylyl)-5-(4-tert-butyl)phenyl-1,3,4-oxadiazole (PBD), 8-hydroxyquinoline aluminum (Alq₃), 4,7-diphenyl- 1,10-phenanthroline (Bphen), 1,2,4-triazole derivatives (e.g., TAZ) or N-arylbenzimidazole (TPBi), and the thickness thereof may be 40 to 80 nm.

Preferably, the material for the electron transport layer 60 is TPBi, and the thickness thereof is 60 nm.

The material for the electron injection layer 70 may be lithium carbonate (Li₂CO₃), lithium chloride (LiCl) or lithium fluoride (LiF), and the thickness thereof may be 0.5 nm to 5 nm.

Preferably, the material for the electron injection layer 70 is LiF, and the thickness thereof is 0.7 nm.

The material for the cathode 80 may be silver (Ag), aluminum (Al), platinum (Pt) or gold (Au), and the thickness thereof may be 80 nm to 250 nm.

Preferably, the material for the cathode 80 is Ag, and the thickness thereof is 100 nm.

In the following, the doped organic electroluminescent device and the method for preparing the same will be described in further detail by referring to the figures and specific embodiments.

The instruments used in the following examples for preparation and testing are as follows: high-vacuum coating equipment (Shenyang Scientific Instrument Development Center Co., Ltd., pressure: < 1 × 10⁻³ Pa), current - voltage tester (Keithly Instruments Inc., USA, Model: 2602), electroluminescent spectrometer (Photo Research, Inc., USA, Model: PR650), and screen luminance meter (Beijing Normal University, Model: ST-86LA).

### Example 1

The doped organic electroluminescent device prepared in this example has the structure of: ITO / MoO₃/ NPB / (TCTA:CsN₃)/ Alq₃/ TPBi / LiF / Ag.

The process for preparing the above doped organic electroluminescent device is as follows.

ITO is first washed sequentially with a detergent, deionized water, acetone, ethanol and isopropyl alcohol under sonication, each for 15 min, to remove organic dirt from the surface of the glass. After cleaning, the glass is subjected to an oxygen plasma treatment. A hole injection layer and a hole transport layer are formed sequentially on ITO by vapor deposition. The material for the hole injection layer is MoO₃, and the thickness thereof is 40 nm. The material for the hole transport layer is NPB, and the thickness thereof is 40 nm. An electron blocking layer having a thickness of 5 nm is then formed by vapor deposition, the material for which is TCTA doped with 5% by mass of CsN₃. A light-emitting layer, an electron transport layer and an electron injection layer are then formed sequentially by vapor deposition. The material for the light-emitting layer is Alq₃, and the thickness thereof is 30 nm. The material for the electron transport layer is TPBi, and the thickness thereof is 60 nm. The material for the electron injection layer is LiF, and the thickness thereof is 0.7 nm. Finally, a cathode is formed by vapor deposition. The material of the cathode is Ag, and the thickness thereof is 100 nm. The desired doped organic electroluminescent device is thus obtained.

Fig. 3 illustrates the relationship between the energy efficiency and the current density of the doped organic electroluminescent device prepared in Example 1 and a conventional doped organic electroluminescent device having a structure of ITO / MoO₃/ NPB / TCTA / Alq₃/ TPBi / LiF / Ag.

As can be seen from Fig. 3, at different current densities, the doped organic electroluminescent device prepared in Example 1 shows higher energy efficiencies than the conventional doped organic electroluminescent device. The maximum energy efficiency of the doped organic electroluminescent device prepared in Example 1 is 15.8 lm/W, while that of the conventional doped organic electroluminescent device is 12.6 lm/W. This demonstrates that, by using a doped electron blocking layer, the LUMO energy level of the hole transport material may be greatly improved, and the hole transport rate may be further improved, and the probability of exciton recombination may ultimately be improved.

### Example 2

The doped organic electroluminescent device prepared in this example has the structure of: IZO / V₂O₅/ TCTA/(TAPC:Cs₂O)/ (TPBi:Ir(ppy)₃)/ TPBi / LiF / Al. The process for preparing the above doped organic electroluminescent device is as follows.

IZO is first washed sequentially with a detergent, deionized water, acetone, ethanol and isopropyl alcohol under sonication, each for 15 min, to remove organic dirt from the surface of the glass. After cleaning, the glass is subjected to an oxygen plasma treatment. A hole injection layer and a hole transport layer are formed sequentially on IZO by vapor deposition. The material for the hole injection layer is V₂O₅, and the thickness thereof is 20 nm. The material for the hole transport layer is TCTA, and the thickness thereof 60 nm. An electron blocking layer having a thickness of 10 nm is then formed by vapor deposition, the material for which is TAPC doped with 15% by mass of Cs₂O. A light-emitting layer, an electron transport layer and an electron injection layer are then formed sequentially by vapor deposition. The material for the light-emitting layer is TPBi doped with 15% by mass of Ir(ppy)₃, and the thickness thereof is 15 nm. The material for the electron transport layer is TPBi, and the thickness thereof is 80 nm. The material for the electron injection layer is LiF, and the thickness thereof is 0.5 nm. Finally, a cathode is formed by vapor deposition. The material of the cathode is Al, and the thickness thereof is 80 nm. The desired doped organic electroluminescent device is thus obtained.

### Example 3

The doped organic electroluminescent device prepared in this example has the structure of: AZO / WO₃/ TPD / (TPD:Cs₂CO₃)/ (NPB:Ir(MDQ)₂(acac))/ Bphen / Li₂CO₃/Au.

The process for preparing the above doped organic electroluminescent device is as follows.

AZO is first washed sequentially with a detergent, deionized water, acetone, ethanol and isopropyl alcohol under sonication, each for 15 min, to remove organic dirt from the surface of the glass. After cleaning, the glass is subjected to an oxygen plasma treatment. A hole injection layer and a hole transport layer are formed sequentially on AZO by vapor deposition. The material for the hole injection layer is WO₃, and the thickness thereof is 80 nm. The material for the hole transport layer is TPD, and the thickness thereof 20 nm. An electron blocking layer having a thickness of 1 nm is then formed by vapor deposition, the material for which is TPD doped with 2% by mass of Cs₂CO₃. A light-emitting layer, an electron transport layer and an electron injection layer are then formed sequentially by vapor deposition. The material for the light-emitting layer is NPB doped with 1% by mass of Ir(MDQ)₂(acac), and the thickness thereof is 2 nm. The material for the electron transport layer is Bphen, and the thickness thereof is 20 nm. The material for the electron injection layer is Li₂CO₃, and the thickness thereof is 5 nm. Finally, a cathode is formed by vapor deposition. The material of the cathode is Au, and the thickness thereof is 250 nm. The desired doped organic electroluminescent device is thus obtained.

### Example 4

The doped organic electroluminescent device prepared in this example has the structure of: ITO / MoO₃/ TAPC / (TPD:CsF) / (TAZ:Firpic) / TAZ / LiCl / Pt.

The process for preparing the above doped organic electroluminescent device is as follows.

ITO is first washed sequentially with a detergent, deionized water, acetone, ethanol and isopropyl alcohol under sonication, each for 15 min, to remove organic dirt from the surface of the glass. After cleaning, the glass is subjected to an oxygen plasma treatment. A hole injection layer and a hole transport layer are formed sequentially on ITO by vapor deposition. The material for the hole injection layer is MoO₃, and the thickness thereof is 50 nm. The material for the hole transport layer is TAPC, and the thickness thereof 30 nm. An electron blocking layer having a thickness of 8 nm is then formed by vapor deposition, the material for which is TPD doped with 7% by mass of CsF. A light-emitting layer, an electron transport layer and an electron injection layer are then formed sequentially by vapor deposition. The material for the light-emitting layer is TAZ doped with 20% by mass of Firpic, and the thickness thereof is 20 nm. The material for the electron transport layer is TAZ, and the thickness thereof is 75 nm. The material for the electron injection layer is LiCl, and the thickness thereof is 0.5 nm. Finally, a cathode is formed by vapor deposition. The material of the cathode is Pt, and the thickness thereof is 150 nm. The desired doped organic electroluminescent device is thus obtained.

### Example 5

The doped organic electroluminescent device prepared in this example has the structure of: FTO / V₂O₅/ NPB / (NPB:Cs₂O)/ DCJTB / PBD / LiF / Al.

The process for preparing the above doped organic electroluminescent device is as follows.

FTO is first washed sequentially with a detergent, deionized water, acetone, ethanol and isopropyl alcohol under sonication, each for 15 min, to remove organic dirt from the surface of the glass. After cleaning, the glass is subjected to an oxygen plasma treatment. A hole injection layer and a hole transport layer are formed sequentially on FTO by vapor deposition. The material for the hole injection layer is V₂O₅, and the thickness thereof is 55 nm. The material for the hole transport layer is NPB, and the thickness thereof 60 nm. An electron blocking layer having a thickness of 2 nm is then formed by vapor deposition, the material for which is NPB doped with 5% by mass of Cs₂O. A light-emitting layer, an electron transport layer and an electron injection layer are then formed sequentially by vapor deposition. The material for the light-emitting layer is DCJTB, and the thickness thereof is 50 nm. The material for the electron transport layer is PBD, and the thickness thereof is 30 nm. The material for the electron injection layer is LiF, and the thickness thereof is 1 nm. Finally, a cathode is formed by vapor deposition. The material of the cathode is Al, and the thickness thereof is 200 nm. The desired doped organic electroluminescent device is thus obtained.

The above Examples only describe several embodiments of the present invention, and the description is relatively specific and in detail. However, they cannot therefore be construed as limiting the scope of the present invention. It should be noted that those of ordinary skill in the art can make a number of modifications and improvements without departing from the concept the present invention. All these modifications and improvements fall within the scope sought protection in the present invention. Therefore, the scope sought protection in the present invention shall be subject to the appended Claims.

## Claims

1. An doped organic electroluminescent device, comprising a conductive anode substrate, a hole injection layer, a hole transport layer, an electron blocking layer, a light-emitting layer, an electron transport layer, an electron injection layer and a cathode, which are sequentially stacked; **characterized in that** the material of the electron blocking layer is a hole transport material doped with a cesium salt, and the cesium salt accounts for 2% to 15% by mass of the electron blocking layer.

2. The Doped organic electroluminescent device according to Claim 1, **characterized in that** the cesium salt is cesium azide, cesium carbonate, cesium fluoride, or cesium oxide.

3. The Doped organic electroluminescent device according to Claim 1, **characterized in that** the hole transport material is 1,1-bis[4-[N,N'-di(p-tolyl)amino] phenyl]cyclohexane, N,N'-di(3-methylphenyl)-N,N'-diphenyl-4,4'-biphenyl diamine, 4,4',4"-tris(carbazol-9-yl)triphenyl amine, or N,N'-(1-naphthyl)-N,N'-diphenyl-4,4'-biphenyl diamine.

4. The Doped organic electroluminescent device according to Claim 1, **characterized in that** the electron blocking layer has a thickness of 1 nm to 10 nm.

5. The Doped organic electroluminescent device according to Claim 1, **characterized in that** a material for the hole injection layer is molybdenum trioxide, tungsten trioxide or vanadium pentoxide.

6. The Doped organic electroluminescent device according to Claim 1, **characterized in that** a material for the hole transport layer is 1,1-bis[4-[N,N'-di(p-tolyl)amino]phenyl] cyclohexane, N,N'-di(3-methylphenyl)-N,N'-diphenyl-4,4'-biphenyl diamine, 4,4',4"-tris(carbazol-9-yl)triphenyl amine, or N,N'-(1-naphthyl)-N,N'-diphenyl-4,4'-biphenyl diamine.

7. The Doped organic electroluminescent device according to Claim 1, **characterized in that** a material for the light-emitting layer is at least one of 4-(dicyanomethylene)-2-isopropyl-6-(1,1,7,7-tetramethyljulolidin-9-yl-vinyl)-4H-pyran, 8-hydroxyquinoline aluminum, bis(4,6-difluorophenylpyridine-N,C²) picolinatoiridium, bis(2-methyl-dibenzo[f,h]quinoxaline) (acetylacetonato) iridium and tris(2-phenylpyridine) iridium;
or a material for the light-emitting layer is a mixed material comprising 4-(dicyanomethylene)-2-isopropyl-6-(1,1,7,7-tetramethyljulolidin-9-yl-vinyl)-4H-pyran, 8-hydroxyquinoline aluminum, bis(4,6-difluorophenylpyridine-N,C²) picolinatoiridium, bis(2-methyl-dibenzo[f,h]quinoxaline) (acetylacetonato) iridium or tris(2-phenylpyridine) iridium as a guest material and one or two of 1,1-bis[4-[N,N'-di(p-tolyl)amino]phenyl]cyclohexane, N,N'-di(3-methylphenyl)-N,N'-diphenyl-4,4'- biphenyl diamine, 4,4',4"-tris(carbazol-9-yl)triphenyl amine, N,N'-(1-naphthyl)-N,N'-diphenyl-4,4'-biphenyl diamine, 2-(4-biphenylyl)-5-(4-tert-butyl)phenyl-1,3,4-oxadiazole, 8-hydroxyquinoline aluminum, 4,7-diphenyl-1,10-phenanthroline, 1,2,4-triazole derivatives and N-arylbenzimidazole as a host material, **characterized in that** the guest material accounts for 1% to 20% by mass of the mixed material.

8. The Doped organic electroluminescent device according to Claim 1, **characterized in that** a material for the electron transport layer is 2-(4-biphenylyl)-5-(4-tert-butyl)phenyl- 1,3,4-oxadiazole, 8-hydroxyquinoline aluminum, 4,7-diphenyl-1,10-phenanthroline, 1,2,4-triazole derivatives or N-arylbenzimidazole.

9. The Doped organic electroluminescent device according to Claim 1, **characterized in that** a material for the electron injection layer is lithium carbonate, lithium fluoride or lithium chloride.

10. A method for preparing a doped organic electroluminescent device, comprising the steps of:
conducting a pretreatment on a conductive anode substrate;
sequentially forming a hole injection layer and a hole transport layer on the conductive anode substrate by vapor deposition;
providing a hole transport material doped with a cesium salt on the hole transport layer by vapor deposition to form an electron blocking layer; and
sequentially forming a light-emitting layer, an electron transport layer and an electron injection layer and finally a cathode on the electron blocking layer by vapor deposition to give the doped organic electroluminescent device.
